# EUROPEAN PATENT APPLICATION

(11) **EP 2 728 589 A1**
(43) Date of publication of application: **07.05.2014**
(21) Application number: 12805141.4
(22) Date of filing: 29.06.2012
(51) Int. Cl.: H01B 12/06, C01G 1/00, C01G 3/00, C01G 27/00, H01B 13/00

(54) **RE-123 SUPERCONDUCTING WIRE AND METHOD FOR MANUFACTURING THE SAME**

(30) Priority: 30.06.2011 JP 2011146025
(71) Applicant: International Superconductivity Technology Center, Kanagawa 213-0012 (JP); Fujikura Ltd., Tokyo 135-8512 (JP)
(72) Inventor: TOBITA, Hiroshi, Sakura-shi Chiba 285-8550 (JP); YOSHIZUMI, Masateru, Tokyo 135-0062 (JP); IZUMI, Teruo, Tokyo 135-0062 (JP); SHIOHARA, Yuh, Tokyo 135-0062 (JP)
(74) Representative: Cabinet Plasseraud
(86) International application number: PCT/JP2012/066701
(87) International publication number: WO 2013/002372

(57) **Abstract**

An RE123-based superconducting wire includes a base material, an intermediate layer formed on the base material, and an oxide superconducting layer which is formed on the intermediate layer and includes an oxide superconductor having a composition formula represented by RE₁Ba₂Cu₃O_{7-δ} (RE represents one or two or more rare earth elements), in which the oxide superconducting layer includes 0.5 to 10 mol% of a Hf-including compound dispersed in the oxide superconducting layer as an artificial pinning center, a film thickness d of the oxide superconducting layer is d>1 µm, and a current characteristic of J_{cd}/J_{cl}≥0.9 (J_{cl} represents a critical current density when the thickness of the oxide superconducting layer is 1 µm, and J_{cd} represents the critical current density when the thickness of the oxide superconducting layer is d µm) is satisfied.

## Description

### TECHNICAL FIELD

The present invention relates to an RE123-based superconducting wire including artificial pinning centers introduced into a superconducting layer and a method of manufacturing the same.

Priority is claimed on Japanese Patent Application No. 2011-146025, filed June 30, 2011, the content of which is incorporated herein by reference.

### BACKGROUND ART

An RE123-based oxide superconductor has a composition represented by RE₁Ba₂Cu₃O_{7-δ} (RE: rare earth element such as Y or Gd). In addition, the RE123-based oxide superconductor has a higher critical temperature than the temperature of liquid nitrogen (77 K), and the application to superconducting equipment such as superconducting devices, transformers, current-limiting devices, motors and magnets is to be expected.

Generally, a superconductor formed to have favorable crystal orientation using an RE123-based oxide superconductor exhibits strong critical current characteristics in a self-magnetic field. However, when a magnetic field is applied to a superconductor in a superconducting state so as to make a current flow, a Lorentz force is generated in a quantized magnetic flux which has intruded into the superconductor. When the quantized magnetic flux is moved due to the Lorentz force, a voltage is generated in a current direction, and a resistance is generated. Since the Lorentz force increases as the current value increases and the magnetic field intensifies, the critical current characteristics degrade when an external magnetic field becomes strong.

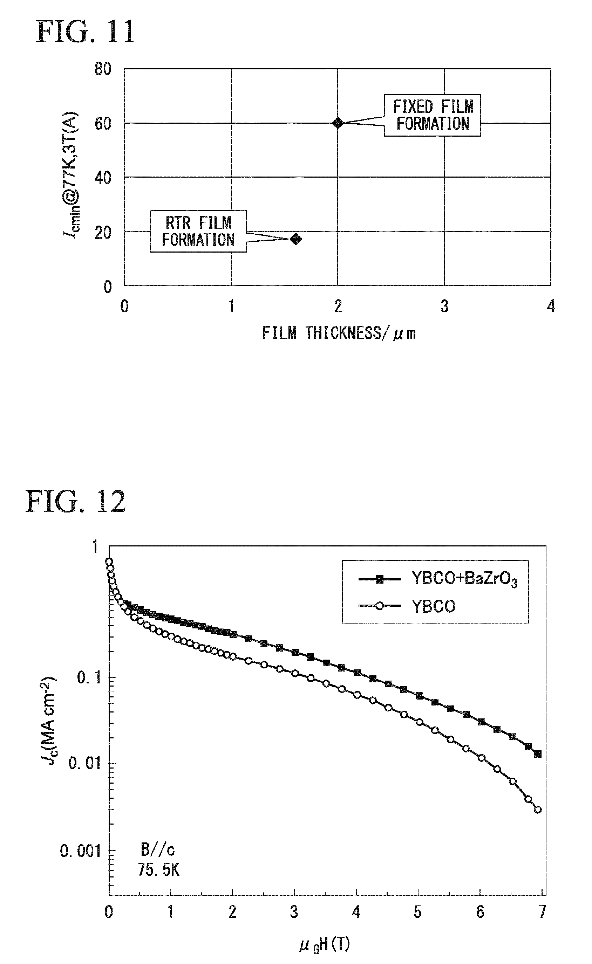

As a solution, generally, a method is known in which a nanoscale foreign phase (a different phase from the superconducting layer), such as an impurity or a defect, is incorporated into the superconducting layer so as to pin the magnetic flux, thereby improving the critical current characteristics in the magnetic field of the superconductor. For example, a method is known in which a normal conductor of a composite oxide including Ba, such as BaZrO₃, is introduced into a superconducting layer including an RE123-based oxide superconductor as an artificial pinning center (in the present specification, also referred to as magnetic flux pinning point or pinning point) (for example, refer to Patent Documents 1 and 2). FIG. 12 is a graph illustrating the characteristics changes of the critical current density J_{c} with respect to an external magnetic field µ_{G}H depending on the introduction of BaZrO₃ into an YBa₂Cu₃O_{7-δ} (YBCO) superconducting layer described in Patent Document 1. As illustrated in FIG. 12, when BaZrO₃ artificial pinning centers are introduced into the YBCO superconducting layer, it is possible to improve the critical current density in the magnetic field (for example, the critical current density improves in a 3T magnetic field from approximately 0.1 MA/cm² to approximately 0.2 MA/cm²) compared to when no artificial pinning centers are introduced.

### PRIOR ART DOCUMENTS

### PATENT DOCUMENTS

[Patent Document 1] United States Patent No. 7737087
[Patent Document 2] PCT International Publication No. WO2009/044637

### DISCLOSURE OF INVENTION

### PROBLEMS TO BE SOLVED BY THE INVENTION

As an example of a method of introducing artificial pinning centers into the RE123-based superconducting layer, a method is known in which a small amount of an impurity such as BaZrO₃ is incorporated during the formation of a superconducting layer using a film-forming method such as a pulsed laser deposition method (PLD method) as described in Patent Documents 1 and 2.

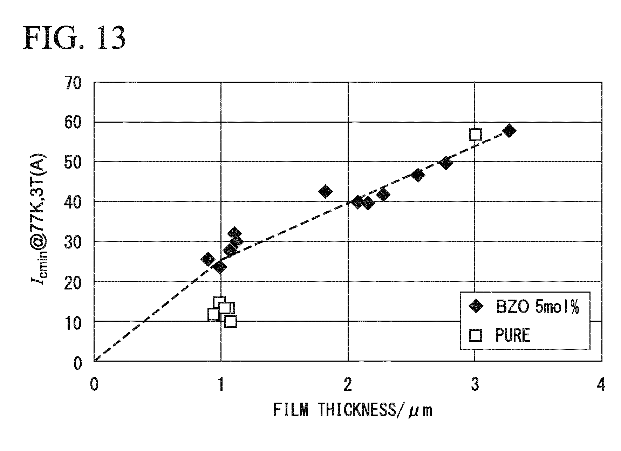

FIG. 13 illustrates a graph plotting a relationship between the film thickness of a GdBa₂Cu₃O_{7-δ} (GdBCO) superconducting layer and the minimum critical current value (I_{cmin}) in an RE123-based superconducting wire manufactured using the PLD method. As illustrated in FIG. 13, when BaZrO₃ (BZO) artificial pinning centers are introduced into a GdBCO superconducting layer, the minimum critical current value (I_{cmin}) improves in a superconducting layer having a film thickness of 1 µm. However, there is a tendency that the degree of the improvement of the critical current characteristics decreases as the film thickness of the RE123-based superconducting layer increases, and, in a superconducting layer having a film thickness of 3 µm, almost the same critical current characteristics as when no artificial pinning centers are introduced are exhibited. This is assumed to be because, when an RE123-based superconducting layer into which artificial pinning centers have been introduced using the PLD method is formed, the artificial pinning center which is a foreign phase (a different phase from the superconducting layer) affects the crystal growth in the RE123-based superconducting layer. As such, in an RE123-based superconducting wire, there is a problem in that the minimum critical current value I_{c} does not increase linearly with respect to the film thickness.

On the other hand, when an RE123-based superconducting layer is formed on a static base material using the PLD method, the temperature control of a film-formed surface is relatively easy. Therefore, even when the thickness of a superconducting layer into which the artificial pinning centers have been introduced is increased, it is possible to maintain the degree of the improvement of the critical current characteristics obtained by the introduction of artificial pinning centers.

However, in order to obtain a long RE123-based superconducting wire, it is necessary to make a long base material transported in the longitudinal direction of the base material and pass through a film-forming area in a film-forming apparatus, thereby continuously forming a superconducting layer. However, when a superconducting layer is continuously formed on a moving base material, the temperature control of a surface on which a film is to be formed becomes difficult as the film thickness of a superconducting layer being formed increases. Therefore, it is not easy to keep the optimal film-forming conditions, and it is difficult to obtain an effect of the introduction of artificial pinning centers that improve the critical current characteristics.

The present invention has been made in consideration of the above circumstances of the related art, and provides an RE123-based superconducting wire which can suppress a decrease in a critical current in a magnetic field and has favorable critical current characteristics even when the film thickness of a superconducting layer exceeds 1 µm, and a method of manufacturing the same.

### MEANS FOR SOLVING THE PROBLEMS

An aspect of a present RE123-based superconducting wire is provided including a base material, an intermediate layer formed on the base material, and an oxide superconducting layer which is formed on the intermediate layer and includes an oxide superconductor represented by a composition formula of RE₁Ba₂Cu₃O_{7-δ} (RE represents one or two or more rare earth elements), in which the oxide superconducting layer includes 0.5 to 10 mol% of a Hf-including compound dispersed in the oxide superconducting layer as an artificial pinning center, a film thickness d of the oxide superconducting layer is d>1 µm, and a current characteristic of J_{cd}/J_{cl}≥0.9 (J_{cl} represents a critical current density when the thickness of the oxide superconducting layer is 1 µm, and J_{cd} represents the critical current density when the thickness of the oxide superconducting layer is d µm) is satisfied.

According to the aspect described above, the Hf-including compound functions as an artificial pinning center (hereinafter, also referred to as magnetic flux pinning point or pinning point), and the degradation of the critical current characteristics in a magnetic field can be suppressed even when the film thickness of the oxide superconducting layer exceeds 1 µm.

In another aspect of the present RE123-based superconducting wire, the Hf-including compound is preferably MHfO₃ (M represents Ba, Sr or Ca).

In the aspect of the RE123-based superconducting wire of the present invention, RE is preferably one or two or more of Gd, Y and Sm.

According to the aspect described above, when an oxide superconducting layer made of RE₁Ba₂Cu₃O_{7-δ} in which RE is one or two or more of Gd, Y and Sm is formed, the superconducting characteristics of the RE123-based superconducting wire become more favorable.

In one aspect of the present RE123-based superconducting wire, M is preferably Ba.

According to the aspect described above, the Hf-including compound which has been introduced into the oxide superconducting layer effectively functions as an artificial pinning center due to the addition of BaHfO₃, and an effect that suppresses the degradation of the critical current characteristics through the application of an external magnetic field further improves.

In one aspect of the present RE123-based superconducting wire, 1.5 to 7.5 mol% or 1.5 to 5.0 mol% of a hafnium composite oxide MHfO₃ (M represents Ba, Sr or Ca) is also preferably dispersed in the oxide superconducting layer.

One aspect of a present method of manufacturing an RE123-based superconducting wire includes, dispersing a Hf-including compound as an artificial pinning center on an intermediate layer formed on a base material using a physical vapor deposition method in which a target is used, adding 0.5 to 10 mol% of a Hf oxide to an oxide superconductor having a composition formula represented by RE₁Ba₂Cu₃O_{7-δ} (RE represents one or two or more rare earth elements) or powder of the oxide superconductor in the target, and forming the oxide superconducting layer which satisfies a current characteristic of J_{cd}/J_{cl}≥0.9 (J_{cl} represents a critical current density when the thickness of the oxide superconducting layer is 1 µm, and J_{cd} represents the critical current density when the thickness of the oxide superconducting layer is d µm) and which has a film thickness d of d>1 µm.

According to the aspect described above, it is possible to provide a new RE123-based superconducting wire which can suppress the degradation of critical current characteristics in a magnetic field even when the film thickness of the oxide superconducting layer exceeds 1 µm.

In the aspect of the present method of manufacturing an RE123-based superconducting wire, an oxide superconducting wire may be formed on the intermediate layer formed on the base material using the pulsed laser deposition method while moving the base material.

### EFFECTS OF THE INVENTION

It is possible to provide an RE123-based superconducting wire which can suppress a decrease in the critical current in a magnetic field and has favorable critical current characteristics even when the film thickness of a superconducting layer exceeds 1 µm, and a method of manufacturing the same.

### BRIEF DESCRIPTION OF THE DRAWINGS

FIG. 1 is a schematic configuration view illustrating an embodiment of an RE123-based superconducting wire according to the present invention.
FIG. 2 is a schematic view illustrating an example of a film-forming apparatus being used in a method of manufacturing a superconductor in the RE123-based superconducting wire according to the present invention.
FIG. 3 is a graph illustrating the characteristics of the critical current densities of RE123-based superconducting wires of Example 1 and Comparative Examples 1 to 3.
FIG. 4 is a graph illustrating the dependencies of the critical current densities of RE123-based superconducting wires of Example 1 and Comparative Examples 1 to 3 on magnetic field applied angles.
FIG. 5A is a TEM photograph of a cross sectional image of an oxide superconducting layer in the RE123-based superconducting wire of Example 1.
FIG. 5B illustrates TEM photographs of cross sectional images of oxide superconducting layers in the RE123-based superconducting wires of Example 1 and Comparative Examples 2 and 3.
FIG. 6A is an electron diffraction pattern of the oxide superconducting layer in the RE123-based superconducting wire of Example 1.
FIG. 6B is an electron diffraction pattern of the oxide superconducting layer in the RE123-based superconducting wire of Comparative Example 2.
FIG. 6C is an electron diffraction pattern of the oxide superconducting layer in the RE123-based superconducting wire of Comparative Example 3.
FIG. 7 is a graph illustrating the dependencies of the critical current densities of RE123-based superconducting wires of Examples 2 and 3 and Comparative Examples 4 and 5 on magnetic field applied angles.
FIG. 8 is a graph illustrating the critical current characteristics of RE123-based superconducting wires of Example 4 and Comparative Examples 6 and 7.
FIG. 9 is a graph plotting J_{cd}/J_{cl} with respect to the film thicknesses of the oxide superconducting layers in the RE123-based superconducting wires of Example 4 and Comparative Examples 6 to 8.
FIG. 10A is a graph illustrating the critical current characteristics of superconducting wires of Examples 5 and 6 and Comparative Examples 9 and 10 depending on magnetization rates at 77 K and in a range of 0T to 5T.
FIG. 10B is a graph illustrating the critical current characteristics of the same superconducting wires depending on magnetization rates at 65K and in a range of 0T to 5T.
FIG. 10C is a graph illustrating the critical current characteristics of the same superconducting wires depending on magnetization rates at 40K and in a range of 0T to 5T.
FIG. 10D is a graph illustrating the critical current characteristics of the same superconducting wires depending on magnetization rates at 20K and in a range of 0T to 5T.
FIG. 11 is a graph illustrating the critical current characteristics of superconducting wires manufactured in examination examples.
FIG. 12 is a graph illustrating the characteristic changes of the critical current density with respect to an external magnetic field depending on the introduction of BaZrO₃ into an YBa₂Cu₃O_{7-δ} superconducting layer.
FIG. 13 is a graph plotting a relationship between the film thickness of a GdBa₂Cu₃O_{7-δ} superconducting layer and the minimum critical current value in an RE123-based superconducting wire manufactured using a PLD method.

### EMBODIMENTS FOR CARRYING OUT THE INVENTION

Hereinafter, an embodiment of an RE123-based superconducting wire of the present invention will be described.

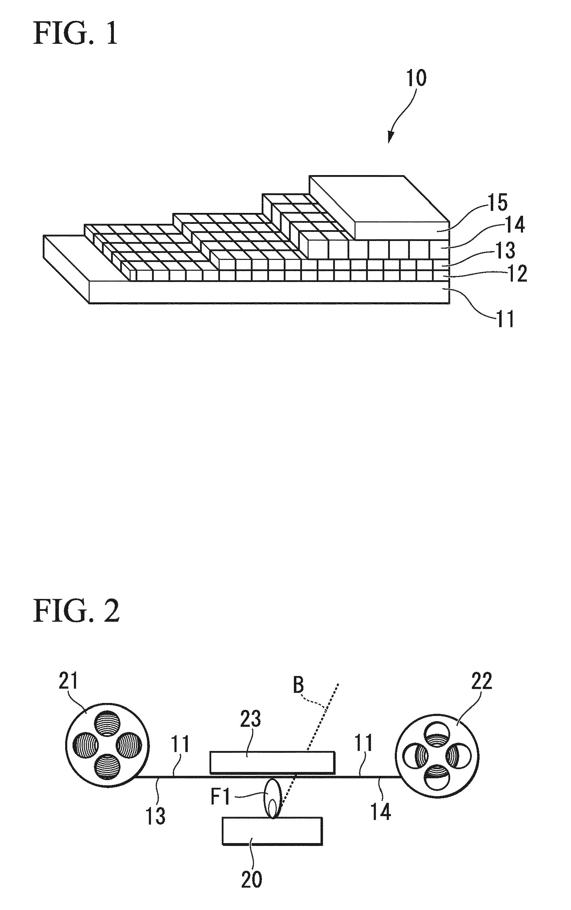

FIG. 1 is a schematic configuration view illustrating the embodiment of the RE123-based superconducting wire according to the present invention.

An RE123-based superconducting wire 10 illustrated in FIG. 1 includes a long base material 11, an intermediate layer 12 formed on the base material 11, a cap layer 13 formed on the intermediate layer 12, an oxide superconducting layer 14 formed on the cap layer 13, and a stabilizing layer 15 formed on the oxide superconducting layer 14.

In the RE123-based superconducting wire of the embodiment, a tape-shaped, plate-shaped or rectangular metallic material can be used as the base material 11. As a material for the base material 11, metal such as Cu, Ni, Ti, Mo, Nb, Ta, W, Mn, Fe or Ag or an alloy thereof which is excellent in terms of strength and heat resistance can be used. The material is preferably stainless steel, HASTELLOY (registered trademark), or a nickel-based alloy due to its excellent corrosion resistance and excellent heat resistance. In addition, an oriented metal substrate such as an oriented Ni-W substrate obtained by introducing a texture into a nickel alloy or the like may be used as the base material 11. The base material 11 can be set in a range of approximately 0.01 to 0.5 mm in thickness in order to be used for an oxide superconducting wire.

The intermediate layer 12 is a thin film formed using an ion beam assist deposition method (IBAD method). As a material for the intermediate layer 12, MgO, GZO (Gd₂Zr₂O₇), YSZ (yttria-stabilized zirconia), SrTiO₃ or the like can be used. Among the above materials, a material having a smaller value of the half width (full width at half maximum, FWHM) Δφ of crystal axis dispersion in an in-plane direction, which is an index that indicates the degree of crystalline orientation, that is, a material which can have a favorable degree of in-plane crystalline orientation is preferably selected. When an oriented metal substrate is used, a film-forming method such as a sputtering method, an electron beam deposition method or a PLD method may be used as well as the IBAD method.

The thickness of the intermediate layer 12 is preferably, for example, in a range of 1 nm to 1.0 µm.

A diffusion prevention layer may be formed between the base material 11 and the intermediate layer 12 in order to prevent the diffusion of elements during a heating treatment. The diffusion prevention layer is highly thermal-resistant, is provided to reduce the interface reactivity, and has a function of providing favorable orientation to the thin film-shaped intermediate layer 12 disposed on the diffusion prevention layer. The diffusion prevention layer may be disposed as necessary, and a material therefor may be, for example, GZO (Gd₂Zr₂O₇), yttria (Y₂O₃), silicon nitride (Si₃N₄), aluminum oxide (Al₂O₃, "alumina") or the like. The diffusion prevention layer is formed in a thickness in a range of several tens of nanometers to 200 nm using, for example, a sputtering method. One diffusion prevention layer or two diffusion prevention layers may be formed.

The cap layer 13 has a function of controlling the orientation of the oxide superconducting layer 14 formed on the cap layer, a function of suppressing the diffusion of elements that form the oxide superconducting layer 14 into other layers, and the like. The cap layer 13 provides a higher degree of in-plane orientation than the intermediate layer 12.

Preferable examples of a material for the cap layer 13 include CeO₂, LMO (LaMnO₃), SrTiO₃, Y₂O₃, Al₂O₃ and the like.

The appropriate film thickness of the cap layer 13 differs depending on the material. For example, when the cap layer 13 is formed of CeO₂, the film thickness may be in a range of 50 nm to 1 µm.

The PLD method, the sputtering method or the like can be used to form the cap layer 13, and the PLD method is desirably used since a large film-forming rate can be obtained.

The oxide superconducting layer 14 is formed of an RE123-based oxide superconductor. In addition, a Hf-including compound is added to the oxide superconducting layer 14 so that a foreign phase including Hf is dispersed. The RE123-based oxide superconductor is a substance having a composition formula represented by RE₁Ba₂Cu₃O_{7-δ} (RE represents one or two or more rare earth elements, and 6.5<7-δ<7.1 is satisfied), and RE is preferably one or two or more of Gd, Y and Sm. When the oxide superconducting layer 14 is formed of RE₁Ba₂Cu₃O_{7-δ} in which RE is one or more of Gd, Y and Sm, the superconducting characteristics of the RE123-based superconducting wire become favorable, which is preferable.

The foreign phase being dispersed in the oxide superconducting layer 14 includes Hf, serves as a normal conduction portion, and functions as an artificial pinning center (magnetic flux pinning point) that controls the movement of a quantized magnetic flux in the oxide superconducting layer 14.

The foreign phase including Hf, which serves as an artificial pinning center, is formed by adding a Hf-including compound to the RE123-based oxide superconductor when forming the oxide superconducting layer 14. The Hf-including compound is preferably a hafnium composite oxide MHfO₃ (M represents Ba, Sr or Ca) or a hafnium oxide HfO₂, and specific examples thereof include BaHfO₃, SrHfO₃ and CaHfO₃. Among the above, BaHfO₃ is particularly preferable since BaHfO₃ effectively functions as a pinning point and has a strong effect that suppresses the degradation of the critical current characteristics by the application of an external magnetic field.

The proportion of the Hf-including compound being added to the oxide superconducting layer 14 is in a range of 0.5 to 10 mol%, preferably in a range of 1.5 to 7.5 mol%, and more preferably in a range of 1.5 to 5.0 mol%. When the Hf-including compound is added to the oxide superconducting layer 14 in the mol% range described above, the proportion of the foreign phase (artificial pinning center) including Hf, which is introduced into the oxide superconducting layer 14, also becomes the same as the proportion of the Hf-including compound. Therefore, the foreign phase including Hf effectively suppresses the movement of a quantized magnetic flux, suppresses a decrease in the critical current in a magnetic field, and enables the obtainment of an RE123-based superconducting wire having favorable critical current characteristics. When the proportion of the Hf-including compound being added to the oxide superconducting layer 14 is less than the lower limit value, there is a probability that it may become difficult to obtain the pinning effect of the foreign phase including Hf which is dispersed as an artificial pinning center. In addition, when the proportion exceeds the upper limit value, since the crystal growth of the RE123-based oxide superconductor in the oxide superconducting layer 14 is affected, there is a probability that the superconducting characteristics of the RE123-based superconducting wire 10 may degrade.

The foreign phase in the oxide superconducting layer 14 can be identified using an X-ray diffraction (XRD) method or an electron diffraction method.

The ratio of the composition of the oxide superconducting layer 14 can be specified using, for example, an ICP atomic emission spectrometry. In addition, the shape or rod diameter of the foreign phase in the oxide superconducting layer 14 can be specified by observing a cross sectional image using a transmission electron microscope (TEM).

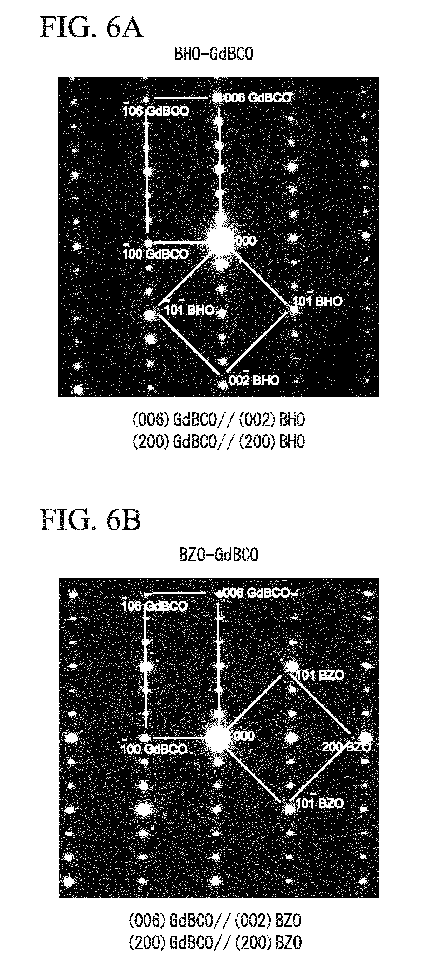

The foreign phase including Hf, which is dispersed in the oxide superconducting layer 14 as a magnetic flux pinning point (artificial pinning center), is a hafnium composite oxide MHfO₃ (M represents Ba, Sr or Ca), HfO₂ or the like, and specific examples thereof include BaHfO₃, SrHfO₃, CaHfO₃, HfO₂ and the like. As described above, when the Hf-including compound which is added to the oxide superconducting layer 14 is BaHfO₃, the artificial pinning center which is the foreign phase including Hf is BaHfO₃, HfO₂ or the like. In examples described below, when BaHfO₃ or HfO₂ is added as the Hf-including compound as illustrated in FIG. 6A, the foreign phase including Hf in the oxide superconducting layer 14 is mainly BaHfO₃.

In addition, there are cases in which, as the magnetic flux pinning point (artificial pinning center) dispersed in the oxide superconducting layer 14, a compound that turns into a normal conductor due to the change in the composition of an RE123-based superconductor such as RE₁₊ₓBa₂₋ₓCu₃O_{7-δ} or an oxide of M described above such as BaO, SrO or CaO is also included in addition to the above compounds.

The proportion of the foreign phase including Hf, which is dispersed in the oxide superconducting layer 14 as an artificial pinning center, becomes substantially the same as the proportion of the Hf-including compound which has been added to the oxide superconducting layer 14. Therefore, the proportion of the foreign phase including Hf in the oxide superconducting layer 14 is, similarly to the addition amount of the Hf-including compound, preferably in a range of 0.5 to 10 mol%, more preferably in a range of 1.5 to 7.5 mol%, and still more preferably in a range of 1.5 to 5.0 mol%.

The thickness d of the oxide superconducting layer 14 is larger than 1 µm, preferably in a range of 1 to 10 µm, and more preferably in a range of 1 to 5 µm. In addition, the thickness of the oxide superconducting layer 14 is preferably uniform.

In the RE123-based superconducting wire 10 of the embodiment, 0.5 to 10 mol% of a Hf-including compound is added to the oxide superconducting layer 14 so as to disperse a foreign phase including Hf in the oxide superconducting layer 14. The foreign phase including Hf functions as a pinning point (magnetic flux pinning point) so that the RE123-based superconducting wire exhibits a current characteristic of J_{cd}/J_{cl}≥0.9 even when the thickness d of the oxide superconducting layer 14 is larger than 1 µm. Here, J_{cl} represents the critical current density when the thickness of the oxide superconducting layer 14 is 1 µm, and J_{cd} represents the critical current density when the thickness of the oxide superconducting layer 14 is d µm.

The fact that J_{cd}/J_{cl} ≥ 0.9 is satisfied indicates that critical current density J_{cd} when the thickness of the oxide superconducting layer 14 is d µm is 90% or more of the value of the critical current density J_{cl} when the thickness of the oxide superconducting layer 14 is 1 µm. Therefore, in the RE123-based superconducting wire 10 of the embodiment, a decrease in the critical current density can be suppressed even when the film thickness of the oxide superconducting layer 14 increases from 1 to d µm.

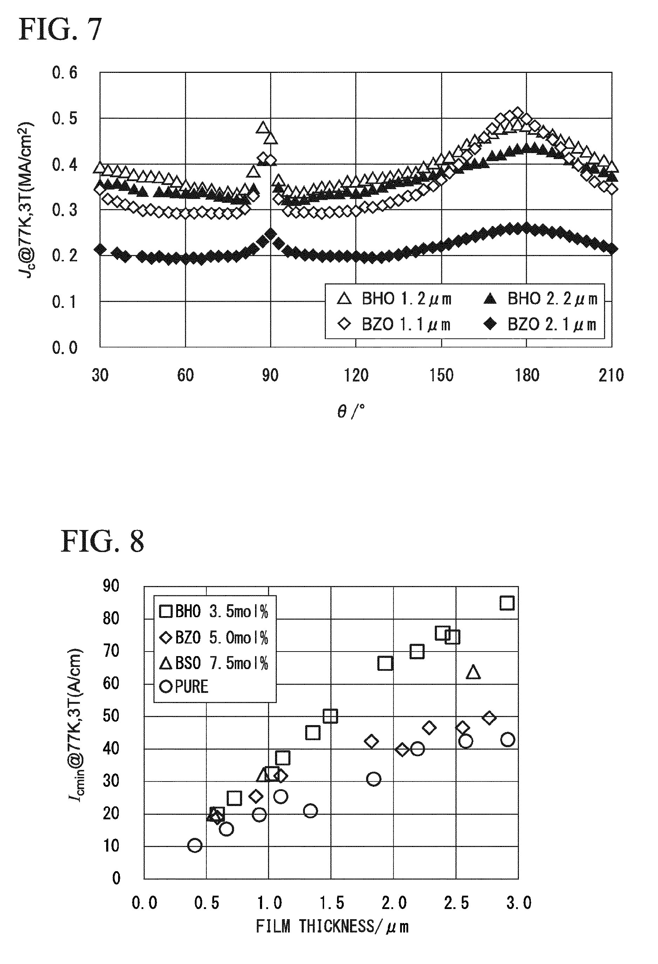

As described above, since the critical current density does not easily decrease even when the film thickness of the oxide superconducting layer 14 increases, in examples described below, as illustrated in FIG. 8, there is a tendency that the critical current value linearly increases in proportion to an increase in the film thickness in the superconducting wire 10 of the embodiment in which BaHfO₃ (BHO) is added to the oxide superconducting layer 14.

The oxide superconducting layer 14 can be stacked using a physical vapor deposition method such as a sputtering method, a vacuum deposition method, a laser deposition method or an electron-beam deposition method; a chemical vapor deposition method (CVD method); a metal organic deposition method (MOD method); or the like. Among the above, in terms of productivity, a pulsed laser deposition method (PLD method), a TFA-MOD method (a metal organic deposition method of organic metal using trifluoroacetate) and a CVD method are preferable, and the PLD method is particularly preferable.

The MOD method refers to a method of applying and then thermally decomposing a salt of an organic acid of metal in which a solution obtained by uniformly dissolving an organic compound of a metal component is applied to a base material and then heated so as to be thermally decomposed, thereby forming a thin film on the base material. Since no vacuum process is required and a film can be formed at a high speed and a low cost, the MOD method is suitable for the manufacturing of oxide superconductors having a long tape shape. In addition, the introduction proportion of the foreign phase including Hf in the oxide superconducting layer 14 being formed can be controlled by adjusting the composition of a raw material solution.

In the CVD method, the introduction proportion of the foreign phase including Hf in the oxide superconducting layer 14 being formed can be controlled by controlling the type and flow rate of a source material gas.

In the PLD method, the introduction proportion of the foreign phase including Hf in the oxide superconducting layer 14 being formed can be controlled by adjusting the composition ratio of a target being used.

In order to form the oxide superconducting layer 14 using the method described above, the composition ratio of a raw material is adjusted so that the Hf-including compound is incorporated into the RE123-based oxide superconductor represented by a composition formula of RE₁Ba₂Cu₃O_{7-δ} in a range of 0.5 to 10 mol%, preferably in a range of 1.5 to 7.5 mol%, and more preferably in a range of 1.5 to 5.0 mol%. Then, a thin film in which the above composition ratio is reflected (oxide superconducting layer 14) can be formed. Specifically, for example, when a film is formed using the PLD method, it is preferable to use a target obtained by incorporating 0.5 to 10 mol% of a powder-form Hf-including compound such as a hafnium composite oxide MHfO₃ into a powder-form RE123-based oxide superconductor represented by a composition formula of RE₁Ba₂Cu₃O_{7-δ} or powder including the constitution elements of the RE123-based oxide superconductor, and then sintering the mixture.

In addition, as the target, it is also possible to use a sintered body obtained by incorporating powder including the constitution elements of a hafnium composite oxide MHfO₃ (for example, HfO₂ or the like) into a powder-form RE123-based oxide superconductor represented by a composition formula of RE₁Ba₂Cu₃O_{7-δ} or powder including the constitution elements of the RE123-based oxide superconductor so as to obtain an incorporation amount of Hf in a range of 0.5 to 10 mol% and then sintering the mixture.

In the present invention, among the methods described above, it is particularly preferable to form the oxide superconducting layer 14 using the PLD method. Hereinafter, as one embodiment of a method of manufacturing the RE123-based superconducting wire of the present invention, the formation of the oxide superconducting layer 14 using the PLD method will be described.
FIG. 2 is a schematic perspective view illustrating an example of a laser deposition apparatus being used to form the oxide superconducting layer 14 using the PLD method. The oxide superconducting layer 14 can be formed using the laser deposition apparatus illustrated in FIG. 2 after the diffusion prevention layer or the intermediate layer 12 and the cap layer 13 are previously formed on the base material 11 using the film-forming method described above.

The laser deposition apparatus illustrated in FIG. 2 includes a reduced-pressure container connected to a pressure-reducing apparatus such as a vacuum pump and can radiate a laser beam B on a target 20 installed in the reduced-pressure container from a laser beam radiation apparatus installed outside the reduced-pressure container. In addition, a supply reel 21, a winding reel 22 and a sheet-like heating apparatus 23 in the middle location between the supply reel and the winding reel are installed in the reduced-pressure container. The tape-shaped base material 11 can be moved from the supply reel 21 to the winding reel 22 through the heating apparatus 23. Particles sputtered or evaporated from the target 20 due to the laser beam B are deposited on the base material 11 that is heated to a desired film-forming temperature in the heating apparatus 23 while being moved, thereby forming a film.

As described above, the target 20 is made of a sheet material such as a sintered body in which a Hf-including compound such as MHfO₃ is incorporated into a composite oxide or an RE123-based oxide superconductor which has an identical or similar composition to the oxide superconducting layer 14 to be formed or includes a large amount of components that are easily removed during the formation of a film at a desired proportion.

The laser deposition apparatus illustrated in FIG. 2 forms a film while transporting the base material 11 in the longitudinal direction at a transportation speed in a range of, for example, 2 to 200 m/h and heating the base material 11 to a preferable temperature (for example, 700 to 1000°C) as the film-forming temperature of the oxide superconducting layer 14. In addition, it is also possible to introduce oxygen gas into the reduced-pressure container as necessary and then form a film in an oxygen atmosphere.

When the laser beam B is radiated on the target 20, a plume F1 of deposition particles sputtered or evaporated from the target 20 is disposed on the surface of the cap layer 13 on the base material 11 passing the region opposite to the target 20, and therefore the oxide superconducting layer 14 is formed.

A method in which a film is formed using the PLD method while transporting the base material in the longitudinal direction of the base material, as in the laser deposition apparatus illustrated in FIG. 2, is preferable since the long RE123-based superconducting wire 10 can be manufactured with favorable productivity.

As illustrated in FIG. 13, in a superconducting wire of the related art in which BaZrO₃ artificial pinning centers are introduced into an RE123-based oxide superconducting layer, when the oxide superconducting layer is formed using the PLD method in which a film is continuously formed using the apparatus as illustrated in FIG. 2 while transporting a long base material, there has been a tendency that, as the film thickness of the oxide superconducting layer increases, the effect of the introduction of the artificial pinning centers weakens and the degree of the improvement of the critical current value decreases.

On the other hand, in the RE123-based superconducting wire 10 of the embodiment, even when the oxide superconducting layer 14 having a large film thickness is formed using the PLD method while transporting the base material, a decrease in the critical current due to an increase in the film thickness of the oxide superconducting layer 14 can be suppressed as illustrated in FIG. 8 and excellent critical current characteristics are exhibited.

The stabilizing layer 15 is preferably stacked on the oxide superconducting layer 14 as illustrated in FIG. 1.

The stabilizing layer 15 stacked on the oxide superconducting layer 14 is a principle component that functions as a current bypass route, in which a current flowing in the oxide superconducting layer 14 is commutated when some regions of the oxide superconducting layer 14 are about to turn into a normal conduction state, so as to stabilize the oxide superconducting layer 14 and prevent burnout.

The stabilizing layer 15 is preferably formed of a metal having favorable conductivity, and specific examples thereof include silver, silver alloys, copper and the like. A single layer of the stabilizing layer 15 may be provided, or the stabilizing layer may be provided in a laminate structure of two or more layers.

The stabilizing layer 15 can be stacked using a well-known method, and it is possible to form a silver layer using plating or a sputtering method and to attach a copper tape or the like on the silver layer. The thickness of the stabilizing layer 15 may be in a range of 0.1 to 300 µm.

In the RE123-based superconducting wire 10 of the embodiment, 0.5 to 10 mol% of a Hf-including compound is added to the oxide superconducting layer 14 so as to disperse the foreign phase including Hf in the oxide superconducting layer 14. The foreign phase including Hf functions as a pinning point and can suppress the degradation of the critical current characteristics in a magnetic field even when the film thickness of the oxide superconducting layer 14 is d>1 µm.

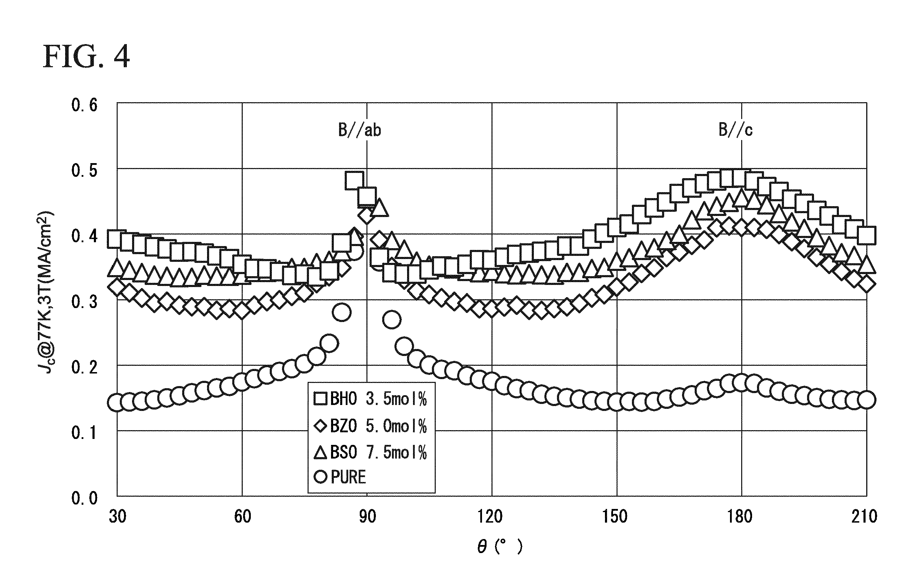

In addition, in examples, a number of nanosized (rod diameter of approximately 5 nm) columnar crystals (nanorods) formed by adding MHfO₃ to the oxide superconducting layer are precipitated and dispersed in the RE123-based superconducting wire 10 of the embodiment, in which 0.5 to 10 mol% of the hafnium composite oxide MHfO₃ is added to the oxide superconducting layer 14, as illustrated in FIG. 4 described below. Therefore, compared with a superconducting wire into which a BaZrO₃ artificial pinning centers are introduced, the nanorods are assumed to function as pinning points for magnetic fluxes at all angles (directions), and therefore it becomes possible to improve the critical current characteristics at all domains of magnetic field applied angles.

According to the method of manufacturing the RE123-based superconducting wire of the present invention described above, it is possible to provide the RE123-based superconducting wire 10 that can suppress the degradation of the critical current characteristics in a magnetic field even when the film thickness of the oxide superconducting layer 14 exceeds 1 µm.

Thus far, an embodiment of the RE123-based superconducting wire of the present invention has been described; however, in the above embodiment, the configuration of the RE123-based superconducting wire and the method of manufacturing the same are simply an example, and appropriate variations are permitted within the scope of the present invention.

Next, the present invention will be described in more detail by describing examples, but the present invention is not limited to the examples.

### Manufacture of a base material for superconducting wires

In the present examples and comparative examples, the following base material will be used as a base material for superconducting wires.

A 110 nm-thick Gd₂Zr₂O₇ (GZO) layer is formed on a HASTELLOY (registered trademark) C276 (trade name of Haynes International Inc.) base material having a width of 10 mm, a thickness of 0.1 mm and a length of approximately 10 cm using the sputtering method, and, furthermore, a 3 nm-thick MgO layer is formed on the GZO layer using the IBAD method, thereby forming an intermediate layer. Next, an 8 nm-thick LaMnO₃ (LMO) layer is formed on the MgO layer using the sputtering method, and a 500 nm-thick CeO₂ layer is formed on the LMO layer using the PLD method, thereby forming a cap layer on the intermediate layer. A base material for superconducting wires is manufactured using the steps described above.

### (Example 1)

An RE123-based oxide superconducting layer having a film thickness of 1.0 µm is formed on the Ce₂O layer of the base material for superconducting wires manufactured as described above in the following order using the laser deposition apparatus illustrated in FIG. 2.

A long metallic base material is wound around the supply reel in the laser deposition apparatus illustrated in FIG. 2 as a dummy base material. An end portion of the long metallic base material is pulled out, fixed to the winding reel, and installed so that the long metallic base material can be transported in the longitudinal direction from the supply reel to the winding reel. Next, the base material for superconducting wires manufactured as described above is connected to a supply reel side of the long metallic base material, which is the dummy base material installed between the pair of reels, in a manner that a film is to be formed on the CeO₂ layer.

Next, the supply reel and the winding reel are driven in synchronization with each other so as to transport the long metallic base material in the longitudinal direction and to transport the base material for superconducting wires which is fixed to the long metallic base material from the supply reel to the winding reel. An RE123-based oxide superconducting layer having a film thickness of 1.6 µm is formed on the CeO₂ layer while the base material for superconducting wires passes through a film-forming region opposite to a target.

A target obtained by sintering powder manufactured by incorporating 1.5 mol% of BaHfO₃ into powder of GdBa₂Cu₃O_{7-δ} is used in the formation of the oxide superconducting layer. The film-forming conditions are a temperature of a heating apparatus (heater) of 1070°C, a pressure of 80 Pa, a laser output of 34 W, in an atmosphere with 100% oxygen, and a transportation speed of the base material for superconducting wires of 20 m/h. The base material is made to pass through the film-forming region multiple times under such conditions with the repetitive change of transportation directions of the base material.

Next, a 5 µm-thick Ag layer (stabilizing layer) is sputtered on the oxide superconducting layer, thereby manufacturing an RE123-based superconducting wire.

Furthermore, oxide superconducting layers are formed under the same conditions as above except that the incorporation amount of BaHfO₃ into the target is changed to 2.5 mol%, 3.5 mol%, 5 mol% and 7 mol%, thereby manufacturing RE123-based superconducting wires.

### (Comparative Example 1)

RE123-based superconducting wires are manufactured in the same manner as in Example 1 except that the oxide superconducting layer is formed using a sintered body of GdBa₂Cu₃O_{7-δ} as the target.

### (Comparative Example 2)

RE123-based superconducting wires are manufactured in the same manner as in Example 1 except that the oxide superconducting layer is formed using a sintered body obtained by sintering powder of GdBa₂Cu₃O_{7-δ} into which 3.5 mol%, 5 mol% or 7.5 mol% of BaZrO₃ has been incorporated as the target.

### (Comparative Example 3)

RE123-based superconducting wires are manufactured in the same manner as in Example 1 except that the oxide superconducting layer is formed using a sintered body obtained by sintering powder of GdBa₂Cu₃O_{7-δ} into which 3.5 mol%, 5 mol%, 7.5 mol% or 10 mol% of BaSnO₃ has been incorporated as the target.

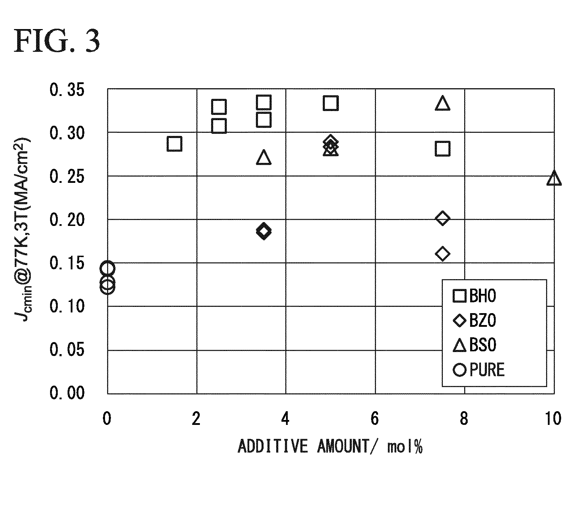

For the RE123-based superconducting wires of Example 1 and Comparative Examples 1 to 3, the critical current characteristics at 77 K in a 3T magnetic field are measured. FIG. 3 illustrates the results in which the minimum values J_{cmin} of the critical current densities of the respective RE123-based superconducting wires are plotted. Meanwhile, in FIG. 3, "BHO" indicates the results of Example 1, "PURE" indicates the results of Comparative Example 1, "BZO" indicates the results of Comparative Example 2, and "BSO" indicates the results of Comparative Example 3.

The results in FIG. 3 show that the critical current density in a 3T magnetic field significantly improves in the RE123-based superconducting wire of Example 1 in which BaHfO₃ is added to an RE123-based oxide superconductor so as to introduce artificial pinning centers compared with the superconducting wire of Comparative Example 1 into which no artificial pinning centers have been introduced. In addition, the effect that improves the critical current characteristics of the superconducting wire into which the artificial pinning centers have been introduced by adding BaHfO₃ is stronger than the effect of the introduction of the artificial pinning centers through the addition of BaSnO₃ when the addition amount is in a range of 1.5 to 5 mol%, and is much stronger than the effect of the introduction of the artificial pinning centers through the addition of BaZrO₃ when the addition amount is in a range of 1.5 to 7.5 mol%.

From the above results, it is found that, when BaHfO₃ is added to the RE123-based oxide superconducting layer in a range of 1.5 to 7.5 mol%, the degradation of the critical current characteristics can be suppressed.

Furthermore, for the RE123-based superconducting wire to which 3.5 mol% of BaHfO₃ (BHO) has been added among the RE123-based superconducting wires of Example 1, the RE123-based superconducting wires of Comparative Example 1, the RE123-based superconducting wire to which 5 mol% of BaZrO₃ (BZO) has been added among the RE123-based superconducting wires of Comparative Example 2, and the RE123-based superconducting wire to which 7.5 mol% of BaSnO₃ (BSO) has been added among the RE123-based superconducting wires of Comparative Example 3, the critical current characteristics at 77 K in a 3T magnetic field are measured. FIG. 4 illustrates the results in which the dependencies of the critical current densities of the respective superconducting wires on magnetic field applied angles are plotted. The minimum value of the critical current density of the superconducting wire of Example 1 at 77 K in a 3T magnetic field, which is indicated by "BHO 3.5 mol%" in FIG. 4 is 0.33 MA/cm². Similarly, the minimum values of "PURE", "BZO 5 mol%" and "BSO 7.5 mol%" are 0.14 MA/cm², 0.28 MA/cm² and 0.33 MA/cm², respectively.

The results in FIG. 4 show that, compared with the superconducting wires of Comparative Examples 1 to 3, the decreases in the critical current densities can be suppressed even when a magnetic field is applied at an angle deviated from the c axis (30°<θ<90°, 90°<θ<150° and the like) in the superconducting wires of Example 1 into which the artificial pinning centers have been introduced by adding BaHfO₃ (BHO) to the RE123-based oxide superconductor. Therefore, it is evident that the RE123-based superconducting wires of Example 1 suppress a decrease in the critical current in a magnetic field and have favorable critical current characteristics. In addition, the superconducting wires of Example 1 can suppress the degradation of the critical current characteristics in a wider range of magnetic field applied angles than the superconducting wires of Comparative Examples 1 to 3. Therefore, in Example 1, compared to Comparative Examples 1 to 3, the nanorods are assumed to function as pinning points for magnetic fluxes at all angles (directions), and therefore it becomes possible to improve the critical current characteristics at all domains of magnetic field applied angles.

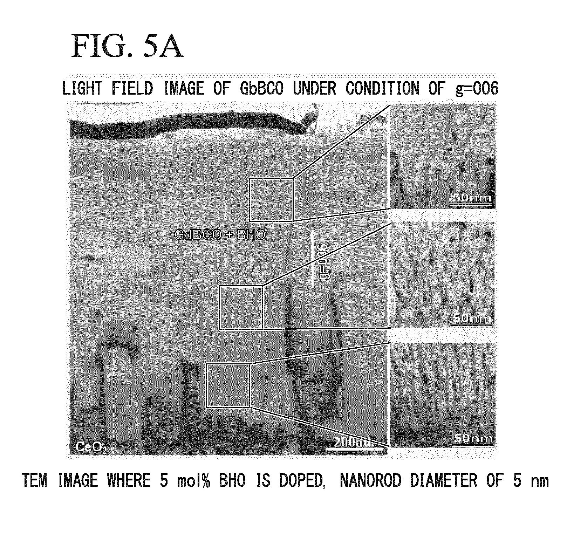

FIG. 5A illustrates the results of transmission electron microscope (TEM) observation of a cross sectional image of the oxide superconducting layer in the superconducting wire to which 5 mol% of BaHfO₃ (BHO) has been added among the RE123-based superconducting wires of Example 1.

As illustrated in FIG. 5A, in the RE123-based superconducting wires of Example 1, a number of columnar crystals (nanorods) having a rod diameter of approximately 5 nm are dispersed in the oxide superconducting layer as pinning points.

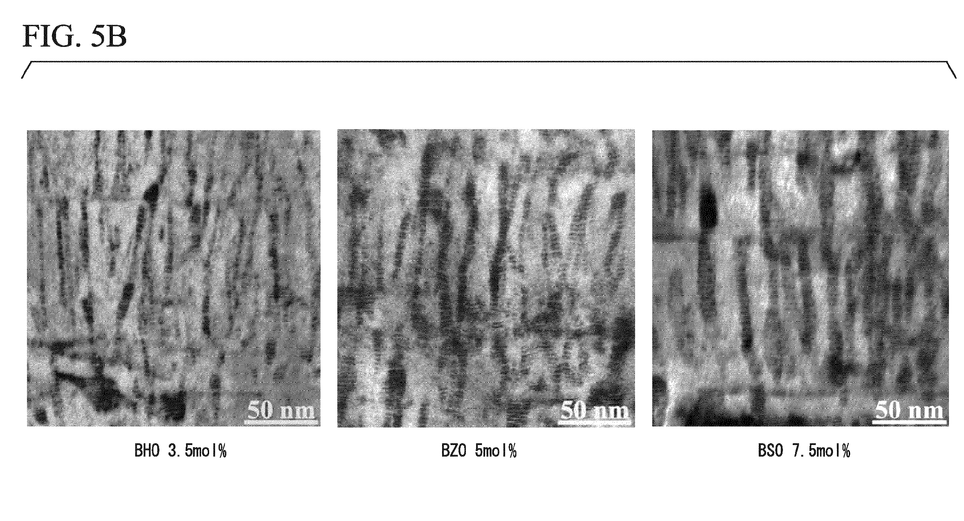

In addition, similarly to FIG. 4, FIG. 5B illustrates the results of transmission electron microscope (TEM) observation of cross sectional images of the oxide superconducting layers in the RE123-based superconducting wires of Example 1 and Comparative Examples 2 and 3. Here, the average rod diameters are 4.5 nm in Example 1, 5.6 nm in Comparative Example 1, and 9.4 nm in Comparative Example 1.

As is evident from FIG. 5B, in Example 1 having the smallest addition amount, a larger number of nanorods having a small diameter are dispersed than in Comparative Examples 2 and 3. Therefore, when the RE123-based superconducting wire of Example 1 is used, it is possible to effectively improve the critical current density in a magnetic field.

Furthermore, for the RE123-based oxide superconducting wires of Example 1 and Comparative Examples 2 and 3 in FIG. 5B, the oxide superconducting layers are analyzed using the electron diffraction method and the ICP atomic emission spectrometry. The obtained electron diffraction patterns are illustrated in FIGS. 6A to 6C respectively.

As illustrated in FIG. 6A, in the oxide superconducting layers in the superconducting wires of Example 1, BaHfO₃ crystals are dispersed in GdBa₂Cu₃O_{7-δ} (GdBCO) crystals. In addition, as a result of the ICP atomic emission spectrometry, the composition ratios of the oxide superconducting layers in the superconducting wires (the addition amount of BaHfO₃ is 3.5 mol%) of Example 1 are Gd:Ba:Cu=1.0:2.0:3.0 and Hf/Gd=3.5 mol%. That is, in the RE123-based superconducting wires of Example 1, BaHfO₃ is dispersed in the oxide superconducting as the artificial pinning center, and the introduction proportion of the artificial pinning centers including Hf in the oxide superconducting layer becomes the same as the proportion of the Hf-including compound which has been added to the target.

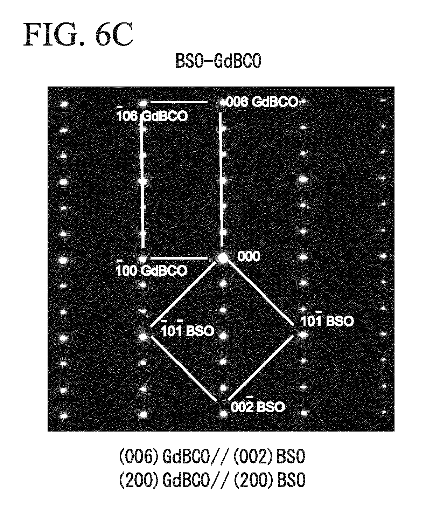

On the other hand, as illustrated in FIG. 6B, in the oxide superconducting layers in the superconducting wires of Comparative Example 2, BaZrO₃ crystals are dispersed in GdBa₂Cu₃O_{7-δ} (GdBCO) crystals. In addition, as illustrated in FIG. 6C, in the oxide superconducting layers in the superconducting wires of Comparative Example 3, similarly, BaSnO₃ crystals are dispersed.

### (Example 2)

RE123-based superconducting wires are manufactured in the same order and conditions as in Example 1 except that a target obtained by sintering powder manufactured by incorporating 3.5 mol% of BaHfO₃ (BHO) into powder of GdBa₂Cu₃O_{7-δ} is used and the film thickness of the oxide superconducting layer is set to 1.2 µm.

### (Example 3)

RE123-based superconducting wires are manufactured in the same order and conditions as in Example 1 except that a target obtained by sintering powder manufactured by incorporating 3.5 mol% of BaHfO₃ (BHO) into powder of GdBa₂Cu₃O_{7-δ} is used and the film thickness of the oxide superconducting layer is set to 2.2 µm.

### (Comparative Example 4)

RE123-based superconducting wires are manufactured in the same order and conditions as in Comparative Example 2 except that a target obtained by sintering powder manufactured by incorporating 5 mol% of BaZrO₃ (BZO) into powder of GdBa₂Cu₃O_{7-δ} is used and the film thickness of the oxide superconducting layer is set to 1.1 µm.

### (Comparative Example 5)

RE123-based superconducting wires are manufactured in the same order and conditions as in Comparative Example 2 except that a target obtained by sintering powder manufactured by incorporating 5 mol% of BaZrO₃ (BZO) into powder of GdBa₂Cu₃O_{7-δ} is used and the film thickness of the oxide superconducting layer is set to 2.1 µm.

For the respective RE123-based superconducting wires of Examples 2 and 3 and Comparative Examples 4 and 5, the critical current densities at 77 K in a 3T magnetic field are measured. FIG. 7 illustrates the results in which the dependencies of the critical current densities of the superconducting wires on magnetic field applied angles are plotted. In FIG. 7, "BHO 1.2 µm" represents the results of Example 2, "BHO 2.2 µm" represents the results of Example 3, "BZO 1.1 µm" represents the results of Comparative Example 4, and "BZO 2.1 µm" represents the results of Comparative Example 5.

According to the results in FIG. 7, in the superconducting wires of Examples 2 and 3 into which the artificial pinning centers have been introduced by adding BaHfO₃ (BHO) to the RE123-based oxide superconductor, the characteristic change in the critical current density is small even when the film thickness of the oxide superconducting layer is increased from 1.2 to 2.2 µm. That is, a decrease in the critical current density due to the increase in the film thickness is successfully suppressed.

On the other hand, in the superconducting wires of Comparative Examples 4 and 5 into which the artificial pinning centers have been introduced by adding BaZrO₃ (BZO), when the film thickness of the oxide superconducting layer is increased from 1.1 to 2.1 µm, the critical current density is significantly decreased. Therefore, it is evident that the present RE123-based superconducting wire into which the artificial pinning centers have been introduced by adding BaHfO₃ (BHO) suppresses a decrease in the critical current density in a magnetic field even when the film thickness of the oxide superconducting layer is set to larger than 1 µm, and has favorable critical current characteristics.

### (Example 4)

A plurality of RE123-based superconducting wires in which the film thickness of the oxide superconducting layer has been changed in a range of 1.1 to 2.9 µm are manufactured in the same order and conditions as in Example 1 except that a target obtained by sintering powder manufactured by incorporating 3.5 mol% of BaHfO₃ (BHO) into powder of GdBa₂Cu₃O_{7-δ} is used.

### (Comparative Example 6)

Similarly to Comparative Example 1, a plurality of RE123-based superconducting wires in which the oxide superconducting layer has been formed using a sintered body of GdBa₂Cu₃O_{7-δ} as the target and the film thickness of the oxide superconducting layer has been changed in a range of 0.5 to 5.2 µm are manufactured.

### (Comparative Example 7)

A plurality of RE123-based superconducting wires in which the film thickness of the oxide superconducting layer has been changed in a range of 0.9 to 3.2 µm are manufactured in the same order and conditions as in Comparative Example 2 except that a target obtained by sintering powder manufactured by incorporating 5 mol% of BaZrO₃ (BZO) into powder of GdBa₂Cu₃O_{7-δ} is used.

### (Comparative Example 8)

A plurality of RE123-based superconducting wires in which the film thickness of the oxide superconducting layer has been changed in a range of 0.9 to 3.2 µm are manufactured in the same order and conditions as in Comparative Example 3 except that a target obtained by sintering powder manufactured by incorporating 7.5 mol% of BaSnO₃ (BSO) into powder of GdBa₂Cu₃O_{7-δ} is used.

For the respective RE123-based superconducting wires of Example 4 and Comparative Examples 6 to 8, the critical currents and the critical current densities at 77 K in a 3T magnetic field are measured. FIG. 8 illustrates the results in which the minimum values I_{cmin} of the critical currents of the respective RE123-based superconducting wires are plotted. In FIG. 8, "BHO 3.5 mol%" represents the results of Example 4, "PURE" represents the results of Comparative Example 6, "BZO 5 mol%" represents the results of Comparative Example 7, and "BZO 7.5 mol%" represents the results of Comparative Example 8.

In addition, RE123-based superconducting wires in which the film thickness of the oxide superconducting layer is 1 µm are manufactured in the same manner as in Example 4, and the critical current densities J_{cl} of the superconducting wires at 77 K in a 3T magnetic field are measured. Next, J_{cd}/J_{cl} is computed using the critical current density J_{cd} of each of the superconducting wires of Example 4 at 77 K in a 3T magnetic field, which has been measured above, and the obtained J_{cl}.

Furthermore, for the superconducting wires of Comparative Examples 6 to 8 as well, the critical current densities J_{cl} of the respective wires when the film thickness of the oxide superconducting layer is 1 µm are measured, and J_{cd}/J_{cl} is measured in the same manner as above.

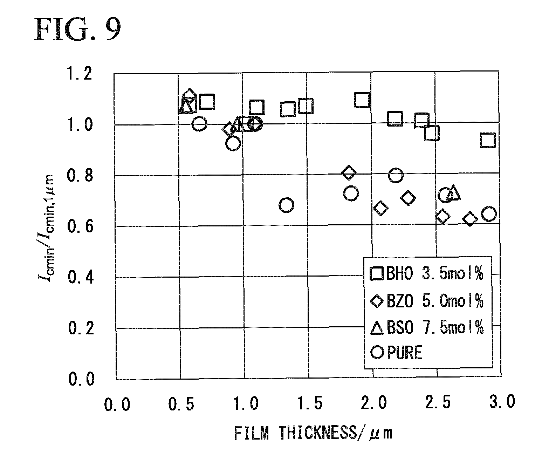

The results in which J_{cd}/J_{cl} with respect to the film thicknesses of the oxide superconducting layers is plotted for the RE123-based superconducting wires of Example 4 and Comparative Examples 6 to 8 are illustrated in FIG. 9.

According to the results in FIG. 8, in the superconducting wires of Example 4 into which the artificial pinning centers have been introduced by adding BaHfO₃ (BHO) to the RE123-based oxide superconductor, the critical current values linearly increase at a substantially constant slope as the film thickness of the oxide superconducting layer increases. On the other hand, in the superconducting wires of Comparative Example 7 into which the artificial pinning centers have been introduced by adding BaZrO₃ (BZO) to the RE123-based superconductor, the degree of the increase in the critical current value begins to slow around when the film thickness of the oxide superconducting layer exceeds 1 µm In the superconducting wires of Comparative Example 8 into which the artificial pinning centers have been introduced by adding BaSnO₃ (BSO) to the RE123-based superconductor, the critical current values do not increase as much as in Example 4.

In addition, in the superconducting wires of Comparative Example 6 in which no artificial pinning centers have been introduced, the critical current values are 70 A when the film thickness of the oxide superconducting layer is 5.2 µm; however, in the superconducting wires of Example 4 according to the present invention, the critical current values reach 85 A when the film thickness of the oxide superconducting layer is 2.9 µm. That is, it is found that a high critical current value can be realized in a thin oxide superconducting layer.

According to the results in FIG. 9, in the superconducting wires of Example 4 into which the artificial pinning centers have been introduced by adding BaHfO₃ (BHO) to the RE123-based oxide superconductor, J_{cd}/J_{cl}>0.9 even when the film thickness of the oxide superconducting layer exceeds 1 µm. That is, even when the film thickness of the oxide superconducting layer is increased, the characteristics of the critical current density slightly change, and a decrease in the critical current density due to an increase in the film thickness can be suppressed.

Therefore, the film thickness of the oxide superconducting layer in Example 4 is preferably in a range of 1 µm to 3 µm, but may be in a range of 1 µm to 5 µm.

### (Example 5)

RE123-based superconducting wires are manufactured in the same order and conditions as in Example 1 except that a target obtained by sintering powder manufactured by incorporating 3.5 mol% of BaHfO₃ (BHO) into powder of GdBa₂Cu₃O_{7-δ} is used and the film thickness of the oxide superconducting layer is set to 1.2 µm.

### (Example 6)

RE123-based superconducting wires are manufactured in the same order and conditions as in Example 1 except that a target obtained by sintering powder manufactured by incorporating 3.5 mol% of BaHfO₃ (BHO) into powder of GdBa₂Cu₃O_{7-δ} is used and the film thickness of the oxide superconducting layer is set to 2.2 µm.

### (Comparative Example 9)

RE123-based superconducting wires are manufactured in the same order and conditions as in Comparative Example 2 except that a target obtained by sintering powder manufactured by incorporating 5 mol% of BaZrO₃ (BZO) into powder of GdBa₂Cu₃O_{7-δ} is used and the film thickness of the oxide superconducting layer is set to 1.2 µm.

### (Comparative Example 10)

RE123-based superconducting wires are manufactured in the same order and conditions as in Comparative Example 2 except that a target obtained by sintering powder manufactured by incorporating 5 mol% of BaZrO₃ (BZO) into powder of GdBa₂Cu₃O_{7-δ} is used and the film thickness of the oxide superconducting layer is set to 2.6 µm.

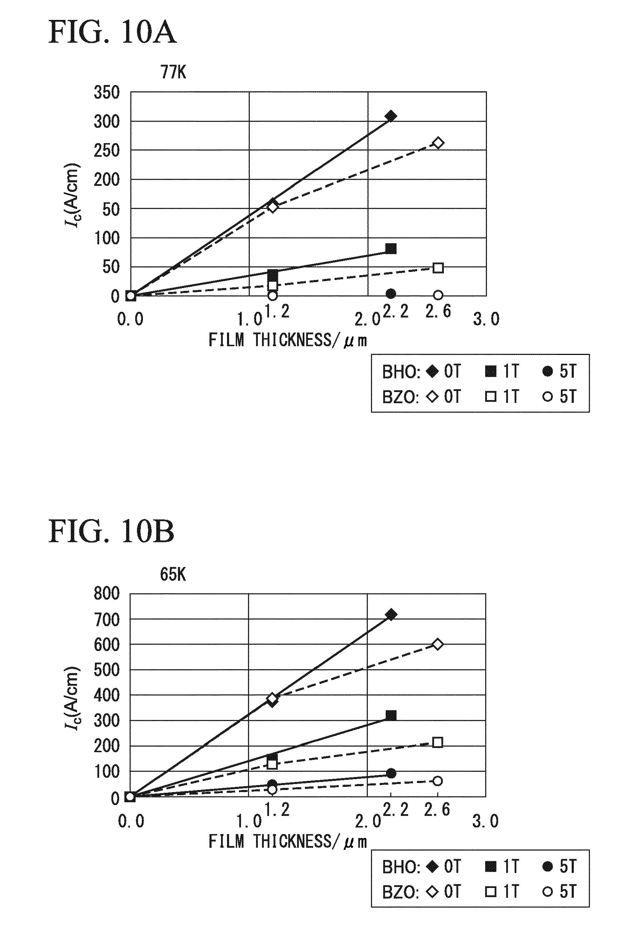

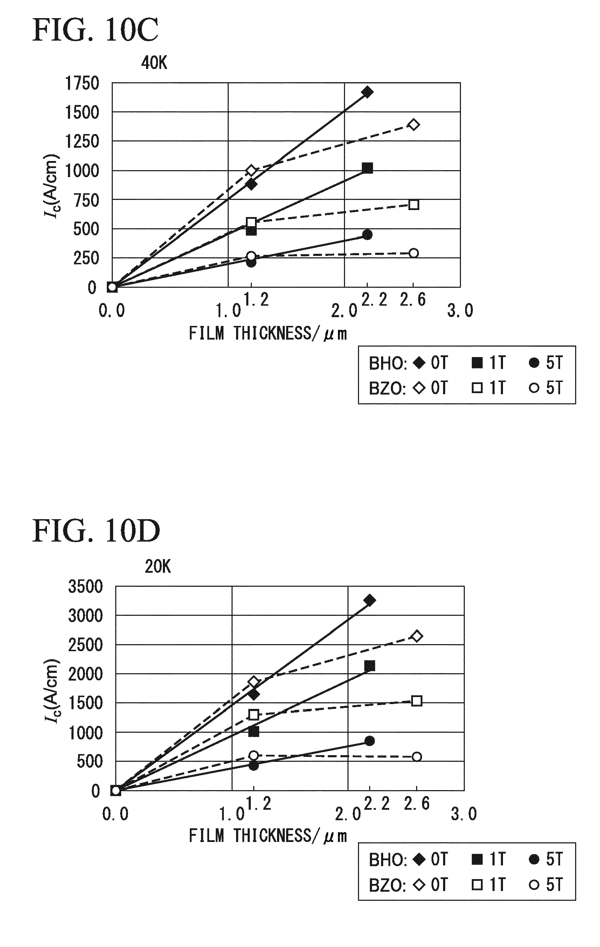

For the respective superconducting wires of Examples 5 and 6 and Comparative Examples 9 and 10, the critical current values at 77 K depending on the magnetization rates in 0T, 1T and 5T magnetic fields are measured. The results are illustrated in FIG. 10A. Similarly, the results measured at 65 K, 40 K and 20 K are illustrated in FIGS. 10B to 10D respectively.

According to the results in FIGS. 10A to 10D, in the superconducting wires of Examples 5 and 6 into which the artificial pinning centers have been introduced by adding BaHfO₃ (BHO) to the RE123-based oxide superconductor, the critical current values linearly increase at a temperature in a range of 20 K to 77 K in a magnetic field in a range of 0 T to 5 T as the film thickness of the oxide superconducting layer increases.

On the other hand, in the superconducting wires of Comparative Examples 9 and 10 into which the artificial pinning centers have been introduced by adding BaZrO₃ (BZO) to the RE123-based oxide superconductor, when the film thickness of the oxide superconducting layer increases, the degree of the increase in the critical current value slows.

Examination Example: Comparison between BaZrO₃ wires where artificial pinning centers are introduced and that are manufactured through fixed film formation and reel to reel film formation

In the following examination example, the same base material as the base material for superconducting wires used for the above superconducting wires is used as the base material for superconducting wires.

When forming an oxide superconducting layer, in any cases of fixed film formation and reel to reel film formation, a sintered body obtained by sintering powder of GdBa₂Cu₃O_{7-δ} into which 5 mol% of BaZrO₃ has been incorporated is used as the target. Films are formed under conditions of a heater temperature of 1070°C, a pressure of 80 Pa, a laser output of 34 W and in an atmosphere with 100% oxygen.

### <Manufacture of a wire through reel to reel (RTR) film formation>

An oxide superconducting layer is formed while transporting the base material for superconducting wires at a transportation speed of 20 m/h using the PLD method in which the laser deposition apparatus illustrated in FIG. 2 is used.

A long metallic base material is wound around the supply reel in the laser deposition apparatus illustrated in FIG. 2 as a dummy base material. An end portion of the long metallic base material is pulled out, fixed to the winding reel, and installed so that the long metallic base material can be transported in the longitudinal direction from the supply reel to the winding reel. Next, the base material for superconducting wires manufactured above is connected to a supply reel side of the long metallic base material, which is the dummy base material installed between the pair of reels, in a manner that a film is to be formed on the CeO₂ layer.

Next, the supply reel and the winding reel are driven in synchronization with each other so as to transport the long metallic base material in the longitudinal direction and to transport the base material for superconducting wires which is fixed to the long metallic base material from the supply reel to the winding reel. An RE123-based oxide superconducting layer having a film thickness of 1.6 µm is formed on a CeO₂ layer while the base material for superconducting wires passes through a film-forming region opposite to a target. The base material is made to pass through the film-forming region multiple times with the repetitive change of transportation directions of the base material until the film thickness of the oxide superconducting layer reaches 1.6 µm.

Next, a 5 µm-thick Ag layer (stabilizing layer) is sputtered on the oxide superconducting layer, thereby manufacturing an RE123-based superconducting wire.

### <Manufacture of a wire through fixed film formation>

The base material for superconducting wires is fixed and disposed so that a CeO₂ layer faces the target, and a 2 µm-thick RE123-based oxide superconducting layer is formed on the CeO₂ layer while the base material for superconducting wires is kept fixed without being transported.

Next, a 5 µm-thick Ag layer (stabilizing layer) is sputtered on the oxide superconducting layer, thereby manufacturing an RE123-based superconducting wire.

For the RE123-based superconducting wires manufactured through the reel to reel film formation (RTR film formation) and the fixed film formation, the critical currents at 77 K in a 3T magnetic field are measured. FIG. 11 illustrates the results in which the minimum values I_{cmin} of the critical currents of each of the RE123-based superconducting wires are plotted.

As illustrated in FIG. 11, in the superconducting wires manufactured through the fixed film formation, the critical current values I_{cmin} are 60 A when the film thickness of the oxide superconducting layer is 2 µm. In the superconducting wires manufactured through the reel to reel film formation (RTR film formation), the critical current values I_{cmin} are 16.9 A when the film thickness of the oxide superconducting layer is 1.6 µm.

From the results described above, it is found that the critical current characteristics are more favorable in the wire where artificial pinning centers are introduced and that are formed through the fixed film formation than in the wire formed through the reel to reel film formation.

When the characteristic values of the fixed film formation, which are obtained in the present examination example, are compared with a graph illustrated in FIG. 13, it is found that, in the fixed film formation, the critical current increases in proportion with the film thickness even with the introduction of the BaZrO₃ artificial pinning centers when the film thickness increases from 1 to 2 µm as well. However, in the BaZrO₃ wire where artificial pinning centers are introduced and that is manufactured through the reel to reel film formation, the increase in the critical current characteristics slows when the film thickness is increased. The characteristics of the superconducting wires illustrated in FIG. 13 are the superconducting characteristics of wires in which the oxide superconducting layer has been formed through the reel to reel film formation.

From the above results, it is found that, in the BaZrO₃ wires where the artificial pinning centers are introduced, when the oxide superconducting layer is formed through the reel to reel film formation (RTR film formation) using the PLD method, the increase in the critical current characteristics slows as the film thickness increases.

On the other hand, in the wires of Examples 1 to 7 into which the artificial pinning centers have been introduced by adding BaHfO₃, the degradation of the critical current characteristics due to an increase in the film thickness can be effectively suppressed even when the oxide superconducting layer is formed through the reel to reel film formation (RTR film formation) using the PLD method.

### INDUSTRIAL APPLICABILITY

The present invention is applied to an RE123-based superconducting wire including artificial pinning centers introduced into a superconducting layer and a method of manufacturing the same.

### DESCRIPTION OF THE REFERENCE SYMBOLS

10: Re123-based superconducting wire
11: Base material
12: Intermediate layer
13: Cap layer
14: Oxide superconducting layer
15: Stabilizing layer
20: Target
21: Supply reel 22: Winding reel 23: Heating apparatus

## Claims

1. An RE123-based superconducting wire comprising:
a base material;
an intermediate layer formed on the base material; and
an oxide superconducting layer which is formed on the intermediate layer and comprises an oxide superconductor represented by a composition formula of RE₁Ba₂Cu₃O_{7-δ} (RE represents one or two or more rare earth elements), wherein:
the oxide superconducting layer comprises 0.5 to 10 mol% of a Hf-including compound dispersed in the oxide superconducting layer as an artificial pinning center;
a film thickness d of the oxide superconducting layer is d>1 µm; and
a current characteristic of J_{cd}/J_{cl}≥0.9 (J_{cl} represents a critical current density when the thickness of the oxide superconducting layer is 1 µm, and J_{cd} represents the critical current density when the thickness of the oxide superconducting layer is d µm) is satisfied.

2. The RE123-based superconducting wire according to Claim 1,
wherein the Hf-including compound is MHfO₃ (M represents Ba, Sr or Ca).

3. The RE123-based superconducting wire according to Claim 1 or 2,
wherein the RE is one or two or more of Gd, Y and Sm.

4. The RE123-based superconducting wire according to any one of Claims 1 to 3,
wherein the M is Ba.

5. The RE123-based superconducting wire according to any one of Claims 1 to 4,
wherein 1.5 to 7.5 mol% of the Hf-including compound is added to the oxide superconducting layer.

6. The RE123-based superconducting wire according to any one of Claims 1 to 4,
wherein 1.5 to 5.0 mol% of the Hf-including compound is added to the oxide superconducting layer.

7. A method of manufacturing an RE123-based superconducting wire, comprising:
dispersing a Hf-including compound as an artificial pinning center on an intermediate layer formed on a base material using a physical vapor deposition method in which a target is used;
adding 0.5 to 10 mol% of a Hf oxide to an oxide superconductor having a composition formula represented by RE₁Ba₂Cu₃O_{7-δ} (RE represents one or two or more rare earth elements) or powder of the oxide superconductor in the target; and
forming the oxide superconducting layer which satisfies a current characteristic of J_{cd}/J_{cl}≥0.9 (J_{cl} represents a critical current density when the thickness of the oxide superconducting layer is 1 µm, and J_{cd} represents the critical current density when the thickness of the oxide superconducting layer is d µm) and which has a film thickness d of d>1 µm.

8. The method of manufacturing an RE123-based superconducting wire according to Claim 7,
wherein the oxide superconducting wire is formed on the intermediate layer formed on the base material using the pulsed laser deposition method while moving the base material.
